(19) Europäisches Patentamt
European Patent Office
Office européen des brevets

(11) Publication number: 0 245 115 B1

# (12) EUROPEAN PATENT SPECIFICATION

(45) Date of publication of patent specification: 08.05.91 Bulletin 91/19

(51) Int. Cl.$^5$: G01R 31/12, G01R 31/28

(21) Application number: 87304121.4

(22) Date of filing: 08.05.87

## (54) Method of and apparatus for testing semiconductor devices.

(30) Priority: 09.05.86 JP 104720/86

(43) Date of publication of application: 11.11.87 Bulletin 87/46

(45) Publication of the grant of the patent: 08.05.91 Bulletin 91/19

(84) Designated Contracting States: DE FR GB NL

(56) References cited:
EP-A- 0 147 921
PATENT ABSTRACTS OF JAPAN, vol. 9, no. 109 (P-355)[1832], 14th May 1985; & JP-A-59 231 458

(73) Proprietor: Oki Electric Industry Company, Limited
7-12, Toranomon 1-chome Minato-ku
Tokyo 105 (JP)

(72) Inventor: Fukuda, Yasuhiro c/o Oki Electric Industry Co. Ltd
7-12 Toranomon 1-chome Minato-ku
Tokyo 105 (JP)

(74) Representative: Boydell, John Christopher et al
Stevens, Hewlett & Perkins 5 Quality Court
Chancery Lane
London WC2A 1HZ (GB)



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a method of and an apparatus for testing electrostatic breakdown of a semiconductor device and for thereby securely and stably monitoring electrostatic breakdown with use of a charged device model damaged due to electrostatic charges stored on a dielectric package of the semiconductor device.

Conventionally, some methods are known for testing electrostatic breakdown of a semiconductor device, such as the charged person method assuming a human body model, and the charged device method and the charged package method assuming a charged device model see e.g. EP-A-0 147 921. Electrostatic breakdown on a user side generally occurs on the charged device model because, with the progress of dimensionally fine semiconductor devices, MOS devices for example have come to have a gate oxide film considerably reduced in thickness, and the processes of fabricating such a semiconductor device are advanced in their automation.

The charged device model is described with reference to Figure 1. In the figure, electrostatic charges 15 have been stored on a package surface 14 of a semiconductor device 11. An input/output terminal 13 is connected to a discharge entity 17, and electrostatic charges are moved from a ground terminal 16 via the discharge entity 17, whereby a discharge current is induced. The induced discharge current damages a semiconductor chip 12.

In the following, a testing method by the charged package method will be described.

As shown in Figure 2, designated at 1 is a semiconductor device enclosed in a plastic package to be tested, such as a MOS IC device, 2 is a semiconductor chip, 3 is an input/output terminal being an electrode of the semiconductor device 1 external thereto, 4 is a surface of the package, 5 is a metal electrode disposed in contact with the package surface 4, 6 is a DC voltage source for supplying voltage to the metal electrode 5, 7 is a reference potential electrode, 8 is load impedance, 9 is a switch connected between the input/output terminal 3 and the impedance 8, and 10 is package capacitance Cp representing the electrostatic capacitance between the semiconductor chip 2 and the metal electrode 5.

In the testing operation, first the switch 9 is opened. Then prescribed voltage is applied to the package surface 4 via the metal electrode 5, with the semiconductor device 1 being insulated from the reference potential electrode 7. In succession, the switch 9 is closed after the lapse of a prescribed time, the input/output terminal 3 is electrically connected with the reference potential electrode 7 via the impedance 8, whereby electric charges are stored on the package capacitance Cp 10. With a current forced so as to flow into the semiconductor chip 2 for storing electric charges on the package capacitance Cp 10, an equivalent phenomenon to the charged device model is produced.

Thereafter, it is judged whether or not the semiconductor device 1 is damaged.

Figure 3 is an equivalent circuit diagram of the conventional apparatus of Figure 2. As shown in the figure, the circuit of the MOS IC device 1 is represented by an input protective diode 22, a capacitance Cox 23 of the gate-insulating film of a MOS transistor and input protective resistance RE 24. Designated at 21 is a voltage source terminal. Other elements have applied to them the same numbers as those shown in Figure 2.

A testing method is often employed which supposes the discharge entity to be metal in general, and hence eliminates the impedance 8 and electrically directly connects between one end of the switch 9 and the reference potential electrode 7. Therefore, the description of the impedance 8 will hereinafter be omitted.

However, upon actual testing of the semiconductor device 1, there is an electrostatic capacitance $C_B$ (hereinafter referred to as back capacitance) between the ground and the power source terminal 21 thereof and electrostatic capacitance $C_I$ (hereinafter referred to as input/output capacitance) between the ground and the input/output terminal 3, as shown in Figure 4. Accordingly, even if the prescribed voltage is applied to the package surface 4, the potential of the power source terminal 21 and the input/output terminal 3 is varied and hence it is difficult to test the semiconductor device 1 highly reliably.

First, the influence of the input/output capacitance $C_I$ will now be described.

Upon executing an electrostatic breakdown test for the semiconductor device 1 with use of the charged package method as shown in Figure 5, the following relation holds between electrostatic capacitance Cair of the air gap existing between a casing piece 30 of a test apparatus and the input/output terminal 3 when the casing piece 30 is present in a confronting relation with the input/output terminal 3 :

$$\begin{aligned} Cair &= (\epsilon o \times \epsilon s \times S)/dl \\ &= (8.855 \times 10^{-14} \times S)/dl \text{..........} (1) \end{aligned}$$

Here, ε o is the vacuum dielectric constant and ε s is a specific dielectric constant of air which is approximately 1. S is an area of the input/output terminal facing to the casing piece 30, which is represented in the cgs unit (the same shall be applied hereinafter).

Here, supposing S = 2 mm × 5 mm = $10^{-1}$ $cm^2$, the relation between the electrostatic capacitance Cair (fF) and the facing distance d1 (cm) described above is as illustrated in Figure 6.

Moreover, the electrostatic capacitance Cair corresponds to the electrostatic capacitance $C_I$ in an equation (2) described later.

Figure 7 is an equivalent circuit diagram of the conventional apparatus taking such input/output capacitance $C_I$ into consideration. As shown in the figure, applied voltage Vcox to an oxide film capacitance Cox 23 when applying prescribed voltage $V_I$ from the DC voltage source 6 with the switch 9 kept opened is generally expressed as :

$$Vcox = \frac{Cp}{Cp + Cox + (CoxCp/CI)} V_1 ......(2).$$

Accordingly, in the example shown in Figure 5,

$$Vcox = \frac{Cp}{Cp+Cox+(d1CoxCp/8.855x10^{-16})} V_1$$

holds.

Supposing here the semiconductor device a 24 pin-DIP plastic packaged semiconductor device, Cp can be assumed to be 7.1 pF (shown in THE PROCEEDINGS OF IEEE INTERNATIONAL RELIABILITY PHYSICS SYMPOSIUM 19th, 1981, pp. 193-199). Assuming here that the oxide film capacitance Cox is approximately 0.3 pF, the equation (2) is changed to

$$Vcox = [7.1/(7.4 + 2405.4\ dl)].\ V_1 ........., \quad (3)$$

and the relation between the facing distance dl and the voltage applied to the oxide film capacitance Cox 23 is given as shown in Figure 8.

Hereupon, forward threshold voltage Vf of the diode 22 of Figure 7 is assumed 0.5 V.

According to Figure 8, the diode 22 of Figure 7 is switched on by only allowing the casing piece 30 of its area S of 2 mm × 5 mm to approach the input/output terminal 3 to about 6 cm therefrom when $V_1$ = 1000 V and to about 3 cm therefrom when $V_1$ = 500 V. Little transient voltage is applied to the oxide film capacitance Cox 23 even if the switch 9 is closed in the above situation and prevents oxide film breakdown from being produced. It can therefore be confirmed that the electrostatic breakdown voltage of the semiconductor device 1 against the electrostatic breakdown measured on the basis of the charged package method shown in Figure 7 is sharply varied by the distance between the casing piece 30 and the input/output terminal 3.

The example described above was a case in which the electrostatic capacitance Cair of the air gap formed between the casing piece 30 and the input/output terminal 3 is the input/output capacitance $C_I$ 26. However provided the testing is effected on a metallic table, the air gap electrostatic capacitance between the table and the input/output terminal 3 acts as the input/output capacitance $C_I$. Accordingly, the electrostatic breakdown voltage data of the semiconductor device 1 is altered furthermore depending on the shape and size of the table.

Next, the influence of the back capacitance $C_B$ will be described.

As shown in Figure 9, a metal piece 32 corresponding to part of a casing of the testing apparatus fixed to the ground potential is placed in the close vicinity of the package surface 4 spaced away by a distance d2 therefrom. The metal piece 32 has an area of 10 mm by 10 mm, for example. Back capacitance $C_B$ parasitizes between the metal piece 32 and the source terminal 21 of the semiconductor device 1.

Figure 10 shows an equivalent circuit of the testing apparatus taking the back capacitance into consideration. The voltage $V_s$ applied to the voltage source terminal 21 of the semiconductor device 1 satisfies in general :

$$V = [Cp/(C_B + Cp)] \cdot V_1 .......... \quad (4)$$

when the DC voltage source 6 is set to a prescribed voltage $V_1$ with the switch 9 opened.

In equation (4), with an increasing back capacitance $C_B$, the voltage $V_s$ at the source terminal 21 is reduced. Thereby, upon closing switch 9, voltage Vcox applied to the gate oxide film capacitance Cox of the MOS transistor is lowered after a prescribed time constant to prevent the oxide film from being damaged.

The voltage of the DC power source 6, being the maximum transient voltage applied to the oxide film capacitor COX 23 after the switch 9 is closed to thereby damage the oxide film is expressed by :

$$V_B = Vcox(\tau)\frac{Cox+CB+Cp}{Cp}\left\{1-e^{-\frac{\tau}{R_E}\left[\frac{Cox+CB+Cp}{Cox(CB+Cp)}\right]}\right\}^{-1} \quad ..(5)$$

Here, e is the logarithmic base, $\tau$ is the response time of the diode 22, and Vcox ($\tau$) is a voltage to be applied to the oxide film capacitor Cox 23 when the diode 22 responds.

Thereupon, the relationship between the distance d2 and the breakdown voltage $V_B$ by means of equation (5), is illustrated graphically in Figure 11. Here, a 16 pin-DIP type plastic encapsulated semiconductor device is employed for the test and Cp = 0.5 pF is assumed. Moreover, Cox = 0.3 pF, $\tau$ = Insec, $R_E$ = 1000. The breakdown voltage is 500 V when the back capacitance $C_B$ = 0.

As evidenced from Figure 11, the breakdown voltage $V_B$ is 670 V when the distance d2 is 0.5 cm, increased no less than 34%. Moreover, upon executing the above testing with the distance d2 varying within 1 cm + 0.5 cm, the breakdown voltage $V_B$ is altered from 670 V to 550 V even if the same semiconductor device is employed. In fact, it is frequently the case that a larger grounding metal piece exists around the portion where the test is executed, and hence the back capacitance $C_B$ is also increased together with the width of the variation.

Accordingly, judgement, upon effecting the electrostatic breakdown testing for the semiconductor device, is varied owing to the changes of the back capacitance $C_B$ and the input/output capacitance $C_I$, and makes it difficult to execute the electrostatic breakdown testing of a semiconductor device with good reproducibility and with high reliability.

The present invention seeks to provide a method and apparatus for the electrostatic breakdown testing of a semiconductor device, which sufficiently takes into consideration the back capacitance $C_B$ and the input/output capacitance $C_I$ and which assures excellent reproducibility and high reliability upon effecting the electrostatic breakdown testing.

According to a first aspect of the invention there is provided a method of testing the electrostatic breakdown voltage of a semiconductor device having a dielectric package when electrostatic charges are applied to the dielectric package, said method comprising the steps of :

(a) connecting a switch in series between an input/output terminal of said semiconductor device and a reference potential source ;

(b) applying a first prescribed potential to the surface of said dielectric package to charge said surface with electric charges while said switch is open ;

(c) applying a second prescribed potential to a terminal of said semiconductor device via a resistor ; and

(d) discharging said charges to said reference potential source by closing said switch.

In an embodiment, shown in Figure 12, the method comprises the steps of :

(a) supplying voltage $V_1$ from a first DC voltage source 41 to the metal electrode 5 disposed in contact with the package surface 4 of the semiconductor device 1 to be tested ;

(b) supplying voltage $V_3$ from a third DC voltage source 43 to the input/output terminal 3 of the semiconductor device 1 via a resistance $r_3$ ; and

(c) supplying voltage $V_2$ from the second DC voltage source 42 to the power source terminal 21 of the semiconductor device 1 via another resistance $r_2$.

In addition, each voltage described above may be applied only to the input/output terminal or the source terminal.

According to a second aspect of the invention there is provided an apparatus for testing the electrostatic breakdown voltage of a semiconductor device having a dielectric package when electrostatic charges are applied to the dielectric package, said apparatus comprising :

(a) a switch connected in series between an input/output terminal of said semiconductor device and a reference potential source ;

(b) a first voltage source for applying a prescribed potential to the surface of said dielectric package to apply electric charges to said surface while said switch is open ;

(c) a second voltage source for applying a prescribed potential to a terminal of said semiconductor device via a resistor ; and

(d) means for discharging said electric charges to said reference potential source by closing said switch.

In order that the invention may be better understood, several embodiments of the invention will now be described by way of example only and with reference to the accompanying drawings in which :

Figure 1 is a schematical view illustrating a charged device model ;
Figure 2 is a schematic view showing a conventional electrostatic breakdown testing apparatus utilising the charged package method ;
Figure 3 is an equivalent circuit diagram of the conventional apparatus ;
Figure 4 is a schematic view showing a further conventional apparatus taking parasitic capacitance into consideration ;
Figure 5 is a view explaining the parasitic behaviour of the input/output capacitance ;
Figure 6 is a graph showing the relationship between the distance d1 and the air gap capacitance Cair in Figure 5 ;
Figure 7 is an equivalent circuit diagram of the conventional apparatus taking input/output capacitance into consideration ;
Figure 8 is a graph showing the relationship between the distance d1 and the voltage applied to oxide film capacitance in Figure 5 ;
Figure 9 is a view explaining the parasitic behaviour of back capacitance ;
Figure 10 is an equivalent circuit diagram of the conventional apparatus taking back capacitance into consideration ;
Figure 11 is a graph showing the relationship between the distance d2 and the breakdown voltalge $V_B$ in Figure 9 ;
Figure 12 is a schematic view showing an embodiment of an electrostatic breakdown testing apparatus according to the present invention ;
Figure 13 is an equivalent circuit diagram of an ideal testing apparatus according to the charged package method ;
Figure 14 is an equivalent circuit diagram of the apparatus taking input/output capacitance into consideration according to the present invention ;
Figure 15 is an equivalent circuit diagram of the apparatus taking back capacitance into consideration ;
Figure 16 is an equivalent circuit diagram of the apparatus taking back capacitance and input/output capacitance into consideration according to the present invention ;
Figure 17 is a schematic view showing another embodiment of the apparatus according to the present invention ; and
Figure 18 is a schematic view showing a still further embodiment of the apparatus according to the present invention.

An embodiment of electrostatic breakdown testing for a semiconductor device according to the present invention will be described with reference to the accompanying drawings.

Figure 13 is an equivalent circuit diagram of an ideal testing apparatus according to the charged package method. In the figure, even if the DC voltage source 6 is set to a prescribed voltage $V_1$ keeping the switch 9 opened, voltage Vcox applied to the oxide film capacitance Cox 23 becomes zero provided the input/output capacitance $C_1$ 26 (refer to Figure 7) is non-existent. Closing the switch 9 in this situation, electric charges are stored on the oxide film capacitance Cox 23 during response time of the diode 22 from off-state to on-state thereof, and thereby the voltage Vcox increases and hence the oxide film is damaged. The voltage Vcox thereupon is much more increased than the threshold voltage Vf of the diode 22. Hereupon, to permit the same voltage to be applied to the oxide film capacitance Cox 23 after closing the switch 9 even if the input/output capacitance C1 26 is existent and varied, a testing equivalent circuit is constructed as shown in Figure 14. Namely, a third DC voltage source 43 is connected with the input/output terminal 3 of the semiconductor device 1 via a resistance $r_3$ 45. With the switch 9 kept open, a first DC voltage source 41 is set to prescribed voltage $V_1$ and the third DC voltage source 43 set to prescribed voltage $V_3$. At this time, the voltage Vcox applied to the oxide film capacitance Cox 23 is as follows :

$$Vcox = [Cp/(Cp + Cox)] \cdot (V_1 - V_3) \ldots\ldots \quad (6)$$

But, with Vcox in excess of the threshold voltage Vf of the diode 22, Vcox = Vf holds.

Hereupon, when executing the ideal electrostatic breakdown testing of the semiconductor device based on the charged package method shown in Figure 13, setting $V_1 = V_3$ causes Vcox = 0.

On the other hand, upon executing the testing when specific input/output capacitance $C_1$ is existent, the voltage $V_3$ may be set as follows :

$$V_3 = \frac{CoxCp}{CpCox + CICox + CICp} V_1 \ldots\ldots\ldots(7)$$

$$\left[\text{if } \frac{CICp}{CpCox+CICox+CICp} V_1 < Vf\right]$$

$$V_3 = \frac{Cp}{Cp + CI} (V_1 - Vf) \ldots\ldots\ldots\ldots(8)$$

$$\left[\text{if } \frac{CICp}{CpCox+CICox+CICp} V_1 > Vf\right]$$

where Vf is threshold voltage of the diode 22. Moreover, the level of the resistance $r_3$ 45 being more than that of the protective resistance $R_E$ 24, does not affect a transient voltage applied to the oxide film capacitance Cox after closure of the switch 9.

In succession, provided the back capacitance $C_B$ 25 is existent as shown in Figures 9 to 11, trouble is caused upon effecting the testing. Also in such a case, i.e. even if the back capacitance $C_B$ 25 is changed in various manners, the test circuit arrangement shown in Figure 15 may be employed for making the voltage $V_s$ of the source terminal 21 constant. Namely, a second DC voltage source 42 is connected with the source terminal 21 of the semiconductor device 1 via the resistance $r_2$ 44. Accordingly, with the switch 9 kept open, the first DC voltage source 41 is set to prescribed voltage $V_1$ and the second DC voltage set to prescribed voltage $V_2$. Then, the voltage $V_s$ of the source terminal 21 of the semiconductor device 1 satisfies $V_s = V_2$ after the application of the voltage described above. Thereupon, when executing the electrostatic breakdown testing for the semiconductor device by making use of the charged package method without the back capacitance $C_B$ 25 as shown in Figure 13, setting the voltages $V_1$, $V_2$ so as to satisfy $V_1 = V_2$ causes $V_s = V_1$. Alternatively, upon executing testing when specific back capacitance $C_B$ 25 is existent, it may be assured by setting the voltage $V_2$ as follows :

$$V = [Cp/(C_B + Cp)] \cdot V_1 \ldots\ldots\ldots \quad (9)$$

There is no difference between transient voltage wave forms, shown in Figures 15 and 10 applied to the oxide film capacitance Cox 23 until the diode 22 starts to respond after closing the switch 9 provided $r_2$ is selected in the range of $r_2$  100 $R_E$, taking into consideration the fact that the response time of a typical diode is less than several nanoseconds.

The current flowing through the diode 22, allows a DC current flowing from the DC voltage source 42 to the resistance $r_2$ 44 – an input protective diode 22 – an input protective resistance $R_E$ 24 – reference potential electrode 7 to be added thereto. This phenomenon is ignored as the electrostatic breakdown testing for the semiconductor device provided the resistance $r_2$ is selected to be more than about $10^6\ \Omega$.

Figure 16 shows a test circuit capable of stably executing electrostatic breakdown testing for a semiconductor device by the charged package method even if the input/output capacitance $C_1$ 26 and the back capacitance $C_B$ 25 both exist and change. With set voltage values $V_1$, $V_2$, and $V_3$ of the respective DC voltage sources 41, 42 and 43 being set by the use of the above equations (6) through (9), test conditions of the charged package method desired to be executed can be prepared.

Figure 17 is a schematic view showing an embodiment of the apparatus according to the present invention.

Prescribed voltage $V_1$ is applied to the package surface 4 of the semiconductor device 1 from the metal electrode 5 electrically connected with the first DC voltage source 41. Voltage $V_3$ is applied to the input/output terminal 3 through a resistor 53 electrically connected with the DC voltage source 43. The voltage $V_2$ is applied to the source terminal 21 through a resistor 52 electrically connected with the second DC voltage source 42. The resistance $r_2$ of the resistor 52 is selected so as to satisfy $r_2$  100 $R_E$ based on Figure 15.

Then, the reference potential electrode 7 and the input/output terminal 3 are short-circuited via the switch 9 for executing an electrostatic breakdown test on the semiconductor device 1. For the switch 9, the reference potential electrode 7 may directly be brought into contact with the input/output terminal 3 or a mercury relay, a lead switch, a semiconductor switch or the like may be employed. For electrical connection between the resistor 53 and the input/output terminal 3, mere contact therebetween may also be allowed. The same will be applied also for electrical connection between the resistor 52 and the source terminal 21.

Figure 18 is a schematic view showing another embodiment of the apparatus according to the present

invention.

Prescribed voltage $V_1$ is applied to the package surface of a semiconductor device 1 from a metal electrode 61 electrically connected with the first DC voltage source 41. The first Dc voltage source 41, the second DC voltage source 42, and the third DC voltage source 43 are electrically connected to a common resistor 64 electrically connected with the input/output terminal 3 and the voltage source terminal 21. The second DC voltage source 42 is set to prescribed voltage $V_2$ and the third DC voltage source 43 set to prescribed voltage source $V_3$. The resistor 64 and a metal electrode 62 are arranged so that the resistance $r_2$ between the source terminal 21 and the second DC voltage source 42 satisfies the relation $r_2$ 100 $R_E$ based on Figure 15.

Then, the reference potential electrode 7 and the input/output terminal 3 are short-circuited via the switch 9 for effecting an electrostatic breakdown test of the semiconductor device 1.

A discharge phenomenon through an air gap formed between the metal electrode 61 and the input/output terminal 3 or the voltage source terminal 21 is prevented from being produced when the switch 9 is switched on, and the electrostatic breakdown testing described above is made possible even if the voltage $V_1$ from the first DC voltage source 41 is increased.

In the embodiments described above, voltage $V_1$ is applied to the package surface of a semiconductor device to be tested via the metal electrode, while prescribed voltages $V_2$ and $V_3$ are applied to the input/output terminal or the voltage source terminal of the semiconductor device via resistance $r_2$ and $r_3$ each having a prescribed range. Hereby, when the prescribed voltage $V_1$ is applied from the DC voltage source to the package surface via the metal electrode, the semiconductor device is not floated from the reference potential electrode. Thus, testing conditions can be prevented from being changed owing to changes of the input/output capacitance and the back capacitance. In addition, with the voltages $V_2$ and $V_3$ being set properly, a breakdown phenomenon by the charged device model in a process where the back capacitance is existent can be reproduced whatever test environment follows. Moreover, a charged voltage reference can be set with ease for each process and for each semiconductor device for preventing a breakdown phenomenon by the charged device model from being produced in an actual assembly process.

In such a manner, the present invention can provide an electrostatic breakdown testing method and the apparatus therefor with high reliability, which are not affected by test environments but rather can create test conditions fitted to the test environments.

## Claims

1. A method of testing the electrostatic breakdown voltage of a semiconductor device (1) having a dielectric package when electrostatic charges (15) are applied to the dielectric package, said method comprising the steps of :

(a) connecting a switch (9) in series between an input/output terminal (3) of said semiconductor device (1) and a reference potential source (7) ;

(b) applying a first prescribed potential (VI) to the surface (4) of said dielectric package to charge said surface (4) with electric charges while said switch (9) is open ;

(c) applying a second prescribed potential (V2, V3) to a terminal (3, 21) of said semiconductor device (1) via a resistor (r2, r3) ; and

(d) discharging said charges to said reference potential source (7) by closing said switch (9).

2. A method of testing a semiconductor device (1) according to claim 1, wherein said application of a prescribed potential in said step (c) is effected to the input/output terminal (3) of said semiconductor device (1).

3. A method of testing a semiconductor device (1) according to claim 1, wherein said application of a prescribed potential in said step (c) is effected to a power source terminal (21) of said semiconductor device (1).

4. A method of testing a semiconductor device (1) according to claim 1, wherein said application of a potential in said step (c) is effected to the input/output terminal (3) of said semiconductor device (1) and to a power source terminal (21).

5. A method of testing a semiconductor device (1) according to claim 1, wherein a load impedance is connected between said switch (9) and said reference potential source (7) in said step (a).

6. An apparatus for testing the electrostatic breakdown voltage of a semiconductor device (1) having a dielectric package when electrostatic charges (15) are applied to the dielectric package, said apparatus comprising :

(a) a switch (9) connected in series between an input/output terminal (3) of said semiconductor device (1) and a reference potential source (7) ;

(b) a first voltage source (41) for applying a prescribed potential to the surface (4) of said dielectric package to apply electric charges to said surface (4) while said switch (9) is open ;

(c) a second voltage source (42, 43) for applying a prescribed potential to a terminal (3, 21) of said semiconductor device (1) via a resistor (53) ; and

(d) means for discharging said electric charges to said reference potential source (7) by closing said switch (9).

7. An apparatus for testing a semiconductor device (1) according to claim 6, wherein said terminal of said semiconductor device (1) is the input/output terminal (3).

8. An apparatus for testing a semiconductor device (1) according to claim 6, wherein said terminal of said semiconductor device (1) is a power source terminal (21).

9. An apparatus for testing a semiconductor device (1) according to claim 6, wherein said terminal in said semiconductor device (1) is the input/output terminal (3) and a power source terminal (21).

10. An apparatus for testing a semiconductor device (1) according to claim 6, wherein impedance means is provided between said switch (9) and said reference potential source (7).

## Ansprüche

1. Verfahren zum Testen der elektrostatischen Durchschlagspannung einer Halbleitereinrichtung (1) mit dielektrischem Gehäuse, wenn elektrostatische Ladungen (15) dem dielektrischen Gehäuse zugeführt werden, wobei das Verfahren folgende Schritte aufweist :

(a) Verbinden eines Schalters (9) in Serie zwischen einem Eingangs/Ausgangs-Anschluß (3) der Halbleitereinrichtung (1) und einer Referenzpotentialquelle (7) ;

(b) Zuführen eines ersten vorgeschriebenen Potentials (V1) zu der Oberfläche (4) des dielektrischen Gehäuses, um die Oberfläche (4) mit elektrischen Ladungen aufzuladen, während der Schalter (9) offen ist ;

(c) Zuführen eines zweiten vorgeschriebenen Potentials (V2, V3) zu einem Anschluß (3, 21) der Halbleitereinrichtung (1) über einen Widerstand (r2, r3) ; und

(d) Entladen der Ladungen zu der Referenzpotentialquelle (7) durch Schließen des Schalters (9).

2. Verfahren zum Testen einer Halbleitereinrichtung (1) nach Anspruch 1, wobei das Zuführen eines vorgeschriebenen Potentials in dem Schritt (c) an dem Eingangs/Ausgangs-Anschluß (3) der Halbleitereinrichtung (1) bewirkt wird.

3. Verfahren zum Testen einer Halbleitereinrichtung (1) nach Anspruch 1, wobei das Zuführen eines vorgeschriebenen Potentials in dem Schritt (c) an einem Netzteilanschluß (21) der Halbleitereinrichtung (1) bewirkt wird.

4. Verfahren zum Testen einer Halbleitereinrichtung (1) nach Anspruch 1, wobei das Zuführen eines Potentials beim Schritt (c) an dem Eingangs/Ausgangs-Anschluß (3) der Halbleitereinrichtung (1) und an dem Netzteilanschluß (21) bewirkt wird.

5. Verfahren zum Testen einer Halbleitereinrichtung (1) nach Anspruch 1, wobei eine Lastimpedanz zwischen dem Schalter (9) und der Referenzpotentialquelle (7) in dem Schritt (a) verbunden wird.

6. Vorrichtung zum Testen der elektrostatischen Durchschlagspannung einer Halbleitereinrichtung (1) mit einem dielektrischen Gehäuse, wenn elektrostatische Ladungen (15) dem dielektrischen Gehäuse zugeführt werden, wobei die Vorrichtung aufweist :

(a) einen Schalter (9), der in Serie zwischen einem Eingangs/Ausgang-Anschluß (3) der Halbleitereinrichtung (1) und einer Referenzpotentialquelle (7) verbunden ist ;

(b) eine ersten Spannungsquelle (41) zum Zuführen eines vorgeschriebenen Potentials zu der Oberfläche (4) des dielektrischen Gehäuses, um elektrische Ladungen dem Gehäuse der Oberfläche (4) zuzuführen, während der Schalter (9) offen ist ;

(c) eine zweite Spannungsquelle (42, 43) zum Zuführen eines vorgeschriebenen Potentials an einem Anschluß (3, 21) der Halbleitereinrichtung (1) über einen Widerstand (53) ; und

(d) eine Einrichtung zum Entladen der elektrischen Ladungen zu der Referenzpotentialquelle (7) durch Schließen des Schalters (9).

7. Vorrichtung zum Testen einer Halbleitereinrichtung (1) nach Anspruch 6, wobei der Anschluß der Halbleitereinrichtung (1) der Eingangs/Ausgangs-Anschluß (3) ist.

8. Vorrichtung zum Testen einer Halbleitereinrichtung (1) nach Anspruch (6), wobei der Anschluß der Halbleitereinrichtung (1) ein Netzteilanschluß (21) ist.

9. Vorrichtung zum Testen einer Halbleitereinrichtung (1) nach Anspruch 6, wobei der Anschluß in der Halbleitereinrichtung (1) der Eingangs/Ausgangs-Anschluß (3) und ein Netzteilanschluß (21) ist.

10. Vorrichtung zum Testen einer Halbleitereinrichtung (1) nach Anspruch 6, wobei eine Impedanzeinrichtung zwischen dem Schalter (9) und der Referenzpotentialquelle (7) vorgesehen ist.

**Revendications**

1. Procédé pour tester la tension de claquage électrostatique d'un dispositif semiconducteur (1) ayant un boîtier diélectrique lorsque des charges électrostatiques (15) sont appliquées au boîtier diélectrique, ledit procédé comprenant les étapes qui consistent :

(a) à connecter un interrupteur (9) en série entre une borne d'entrée/sortie (3) dudit dispositif semiconducteur (1) et une source (7) de potentiel de référence ;

(b) à appliquer un premier potentiel prescrit (V1) à la surface (4) dudit boîtier diélectrique pour charger ladite surface (4) avec des charges électriques tandis que ledit interrupteur (9) est ouvert ;

(c) à appliquer un second potentiel prescrit (V2, V3) à une borne (3, 21) dudit dispositif semiconducteur (1) par l'intermédiaire d'une résistance (r2, r3) ; et

(d) à décharger lesdites charges vers ladite source (7) de potentiel de référence en fermant ledit interrupteur (9).

2. Procédé pour tester un dispositif semiconducteur (1) selon la revendication 1, dans lequel ladite application d'un potentiel prescrit dans ladite étape (c) est effectuée sur la borne d'entrée/sortie (3) dudit dispositif semiconducteur (1).

3. Procédé pour tester un dispositif semiconducteur (1) selon la revendication 1, dans lequel ladite application d'un potentiel prescrit dans ladite étape (c) est effectuée sur une borne (21) d'une source d'énergie dudit dispositif semiconducteur (1).

4. Procédé pour tester un dispositif semiconducteur (1) selon la revendication 1, dans lequel ladite application d'un potentiel dans ladite étape (c) est effectuée sur la borne d'entrée/sortie (3) dudit dispositif semiconducteur (1) et sur une borne (21) de source d'énergie.

5. Procédé pour tester un dispositif semiconducteur (1) selon la revendication 1, dans lequel l'impédance de charge est connectée entre ledit interrupteur (9) et ladite source (7) de potentiel de référence dans ladite étape (a).

6. Appareil pour tester la tension de claquage électrostatique d'un dispositif semiconducteur (1) ayant un boîtier diélectrique lorsque des charges électrostatiques (15) sont appliquées au boîtier diélectrique, ledit appareil comportant :

(a) un interrupteur (9) connecté en série entre une borne d'entrée/sortie (3) dudit dispositif semiconducteur (1) et une source (7) de potentiel de référence ;

(b) une première source (41) de tension destinée à appliquer un potentiel prescrit à la surface (4) dudit boîtier diélectrique pour appliquer des charges électriques à ladite surface (4) tandis que ledit interrupteur (9) est ouvert ;

(c) une seconde source (42, 43) de tension destinée à appliquer un potentiel prescrit à une borne (3, 21) dudit dispositif semiconducteur (1) par l'intermédiaire d'une résistance (53) ; et

(d) des moyens destinés à décharger lesdites charges électriques vers ladite source (7) de potentiel de référence par fermeture de l'interrupteur (9).

7. Appareil pour tester un dispositif semiconducteur (1) selon la revendication 6, dans lequel ladite borne dudit dispositif semiconducteur (1) est la borne d'entrée/sortie (3).

8. Appareil pour tester un dispositif semiconducteur (1) selon la revendication 6, dans lequel ladite borne dudit dispositif semiconducteur (1) est une borne (21) de source d'énergie.

9. Appareil pour tester un dispositif semiconducteur (1) selon la revendication 6, dans lequel ladite borne dans ledit dispositif semiconducteur (1) est la borne d'entrée/sortie (3) et une borne (21) de source d'énergie.

10. Appareil pour tester un dispositif semiconducteur (1) selon la revendication 6, dans lequel un moyen à impédance est prévu entre ledit interrupteur (9) et ladite source (7) de potentiel de référence.

FIG. 1

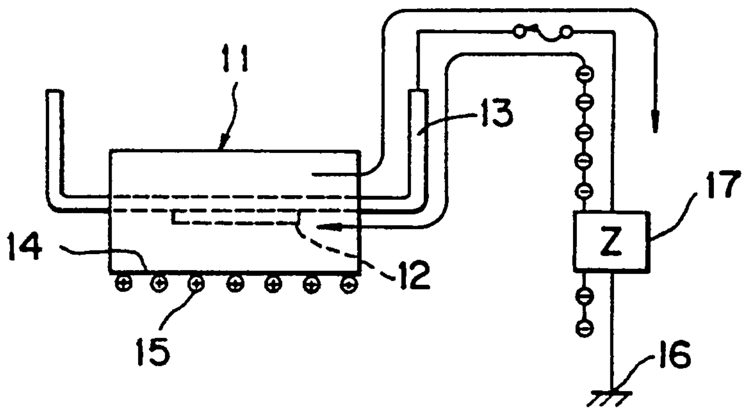


FIG. 2 (PRIOR ART)

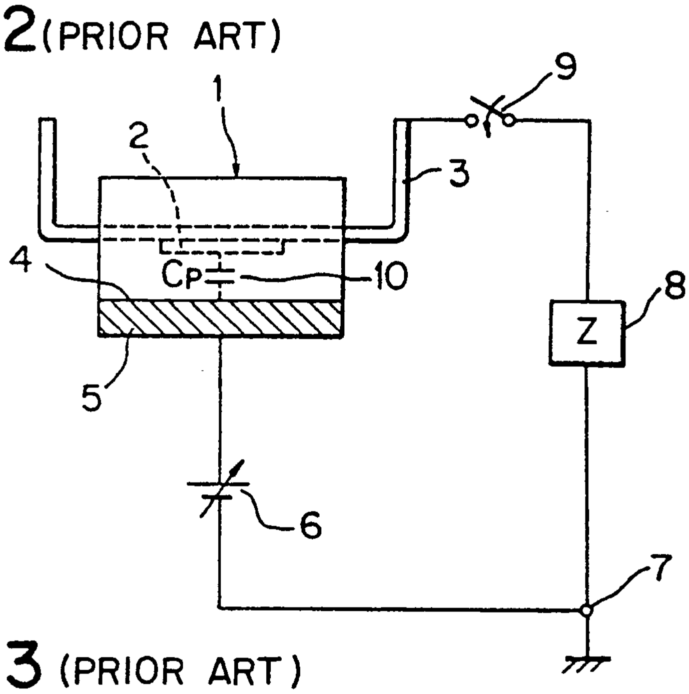


FIG. 3 (PRIOR ART)

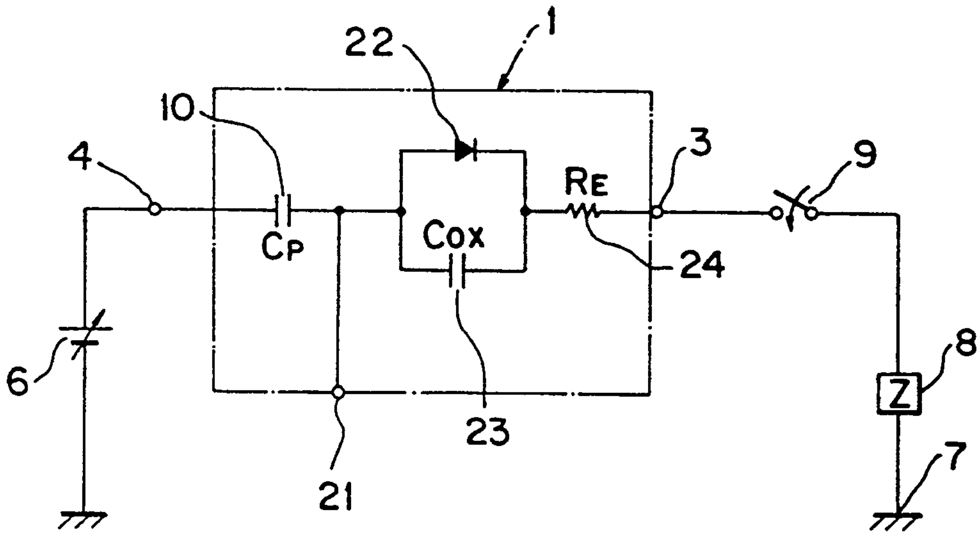

FIG. 4 (PRIOR ART)

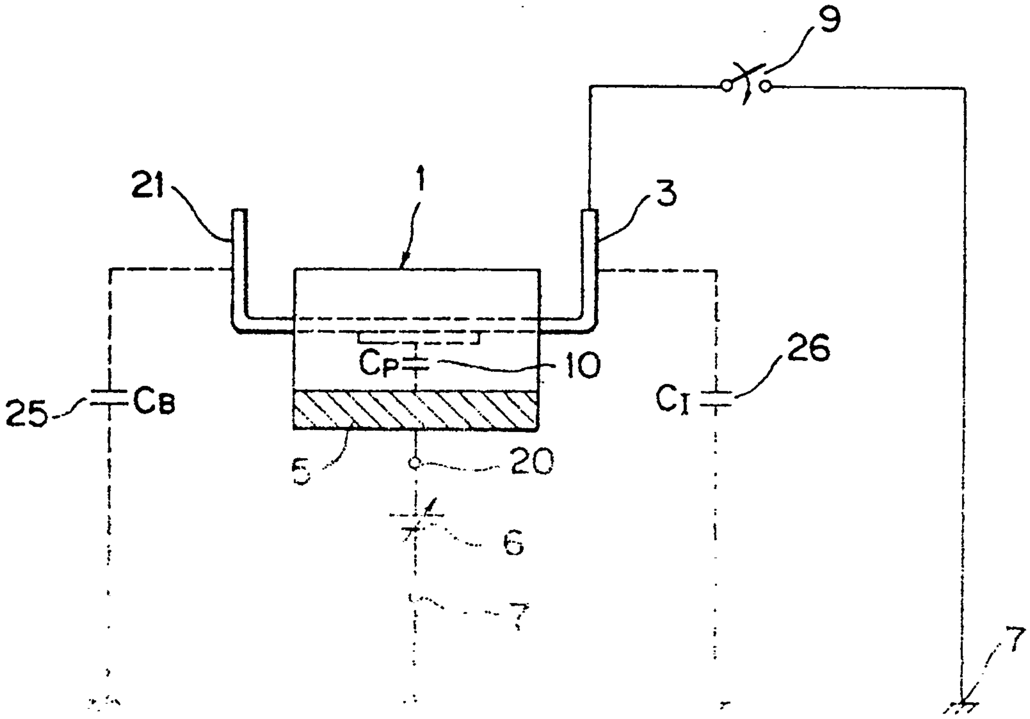


FIG. 5

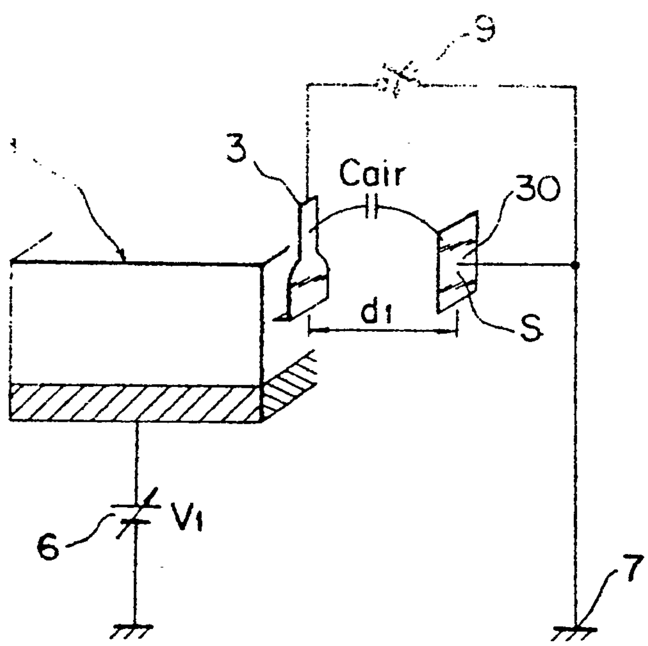

FIG. 6

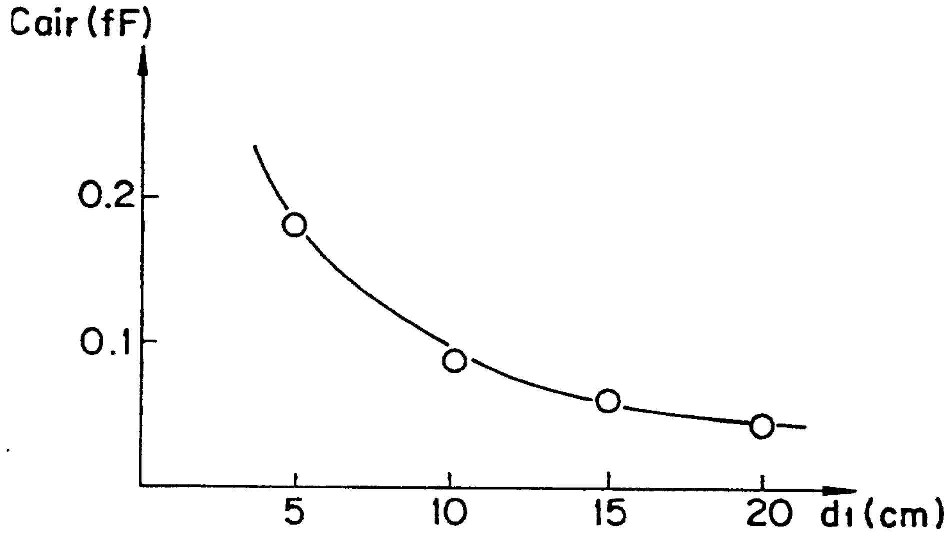
Cair (fF)
0.2
0.1
5
10
15
20
d1 (cm)

FIG. 7

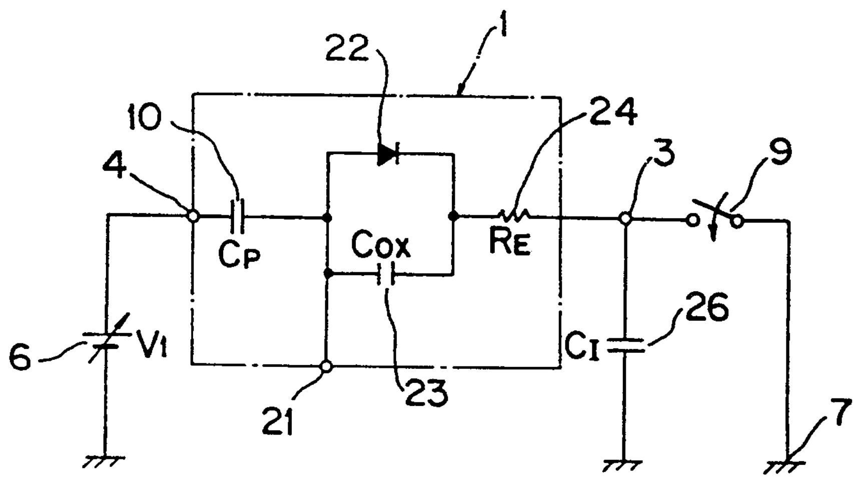
1
22
24
10
4
3
9
CP
COX
RE
6
V1
CI
26
21
23
7

FIG. 8

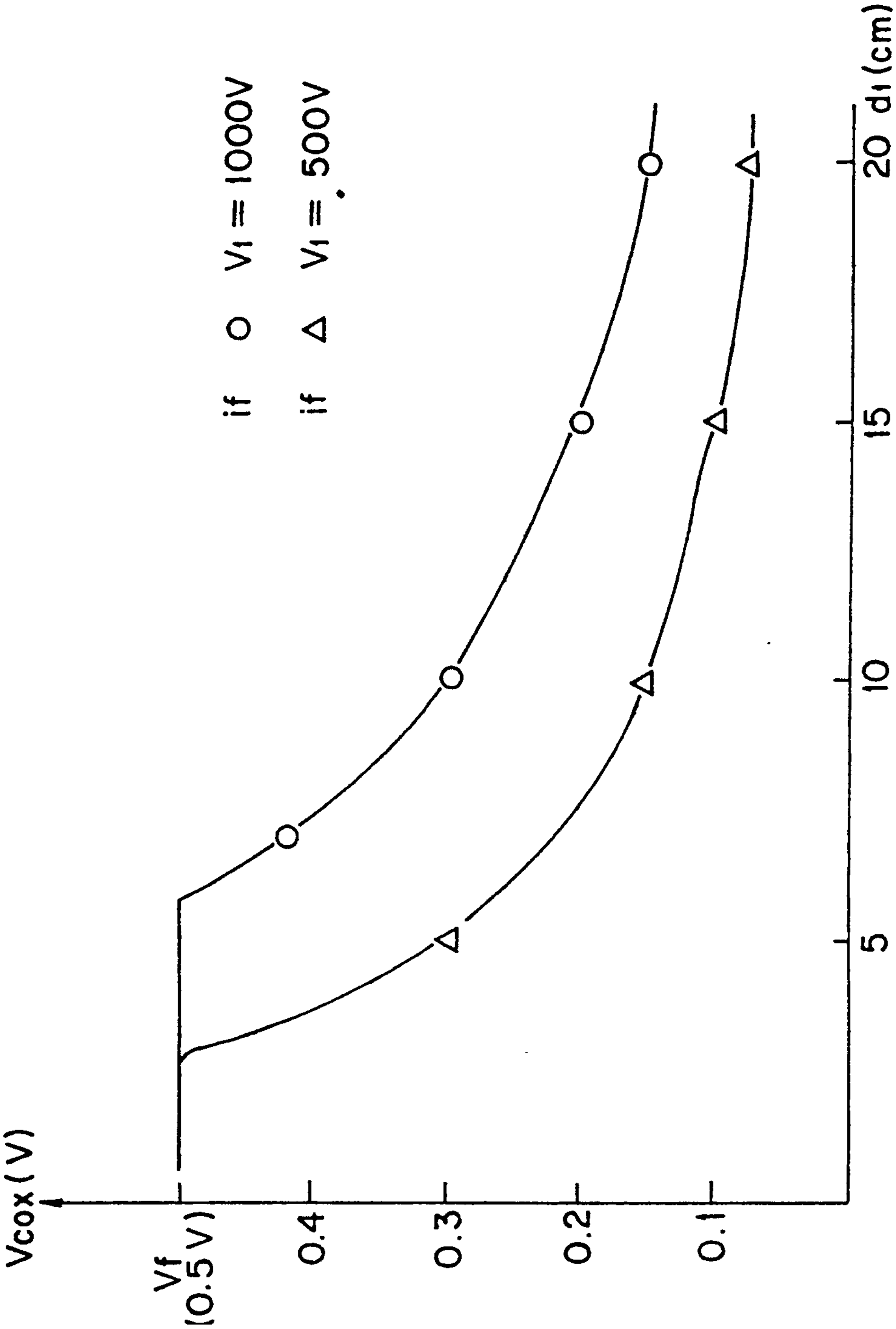

FIG. 9

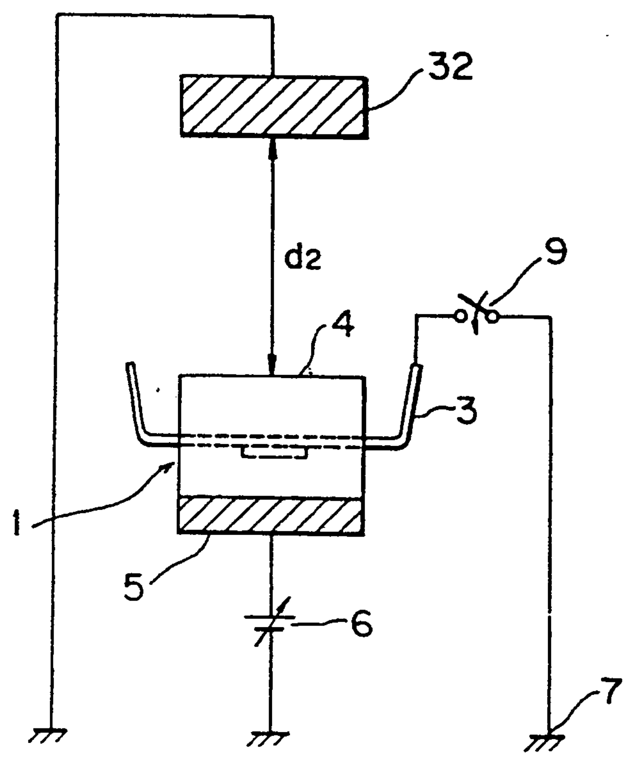


FIG. 10

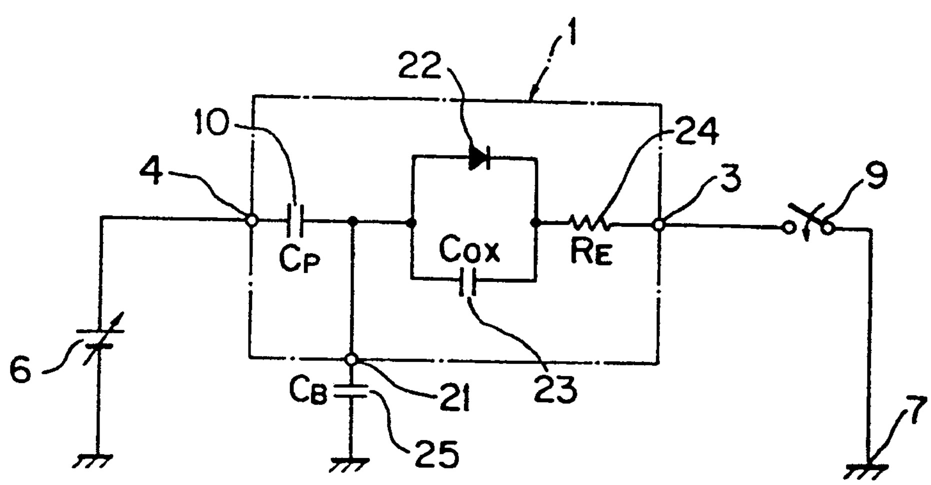

FIG. II

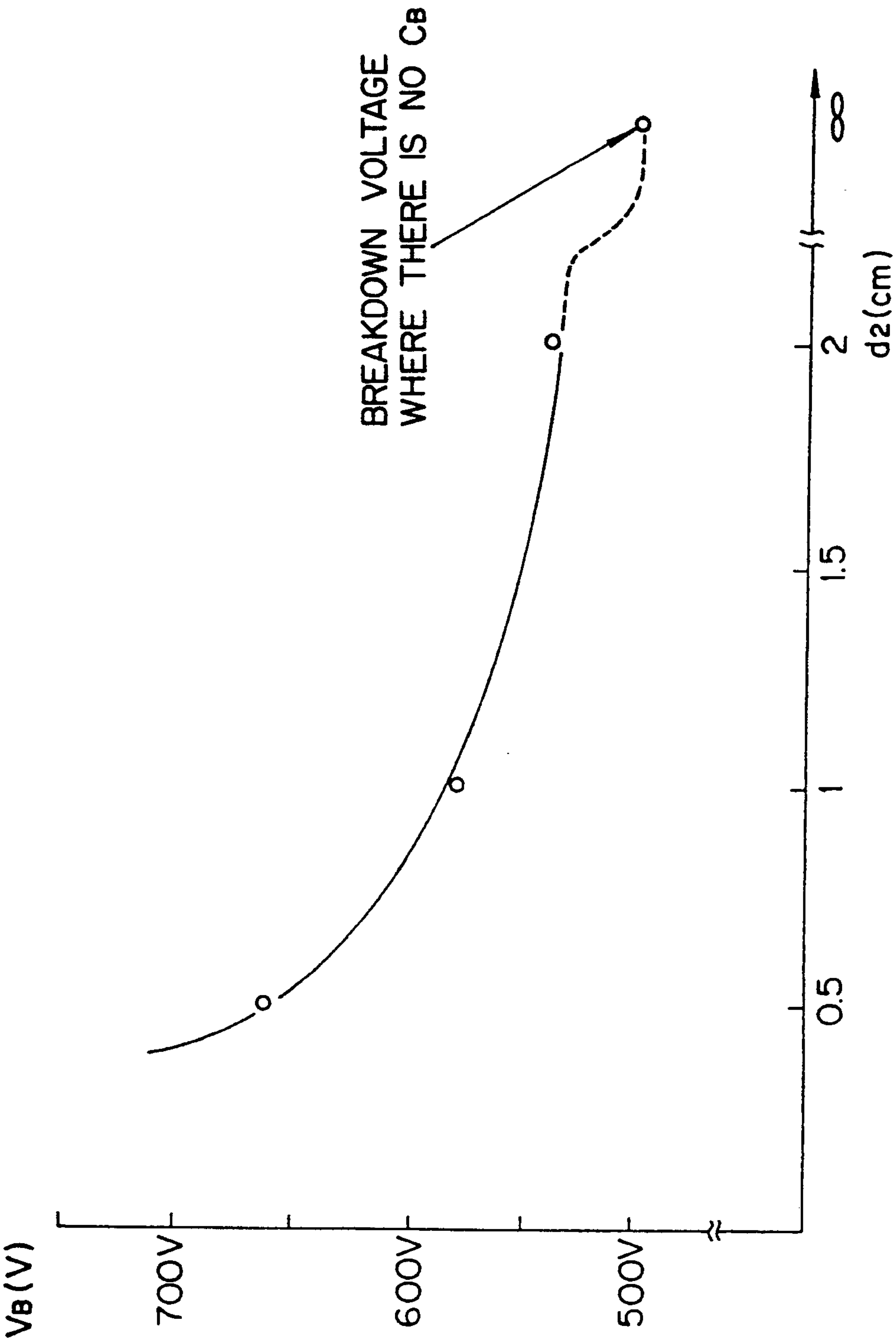
BREAKDOWN VOLTAGE
WHERE THERE IS NO CB
VB(V)
700V
600V
500V
0.5
1
1.5
2
∞
d2(cm)

FIG. 12

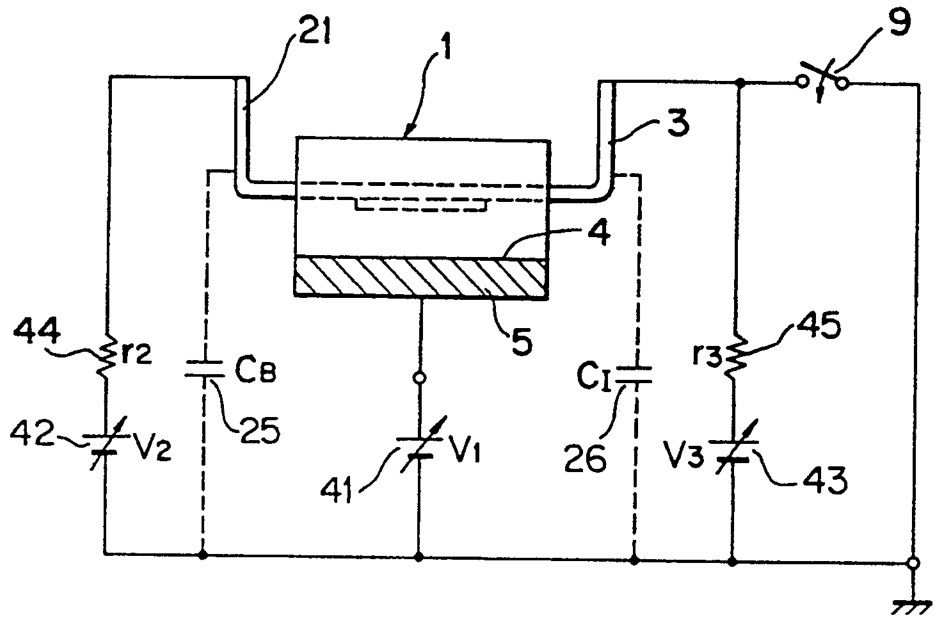

FIG. 13

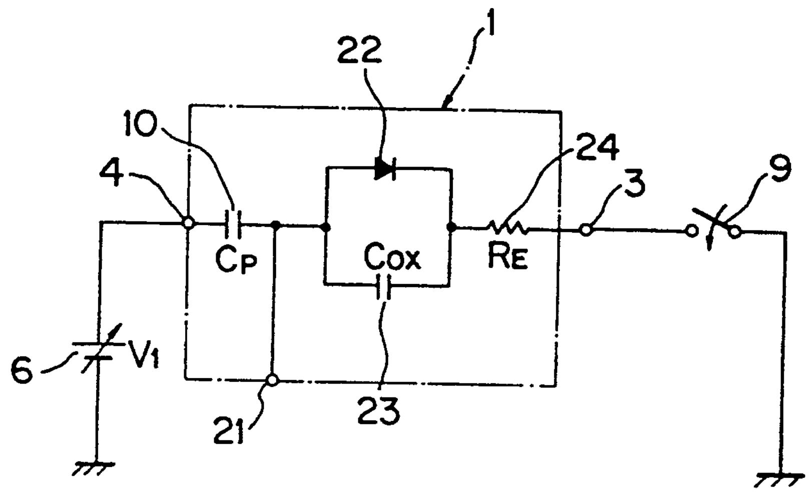
1
22
10
24
4
3
9
CP
Cox
RE
6
V1
21
23

FIG. 14

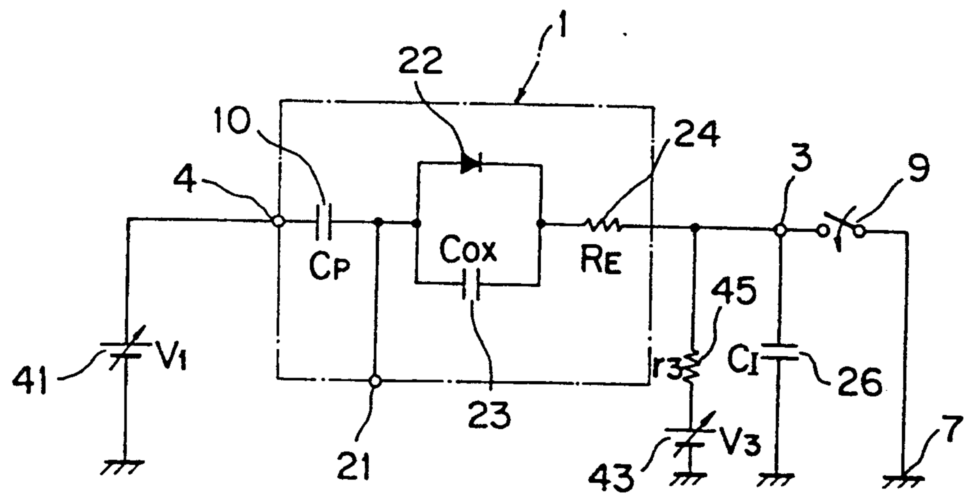
1
22
10
24
3
9
4
CP
Cox
RE
45
41
V1
r3
CI
26
23
7
21
43
V3

FIG. 15

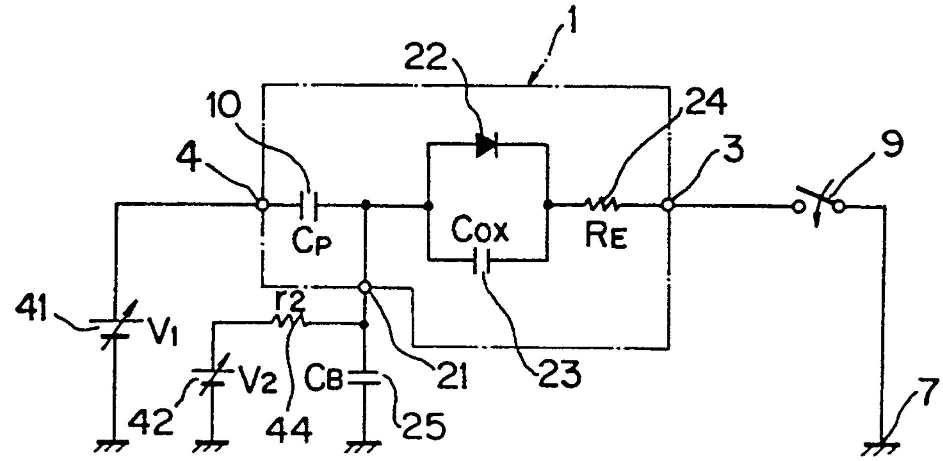
1
22
10
24
4
3
9
Cp
Cox
RE
41
V1
r2
V2
CB
21
23
42
44
25
7

FIG. 16

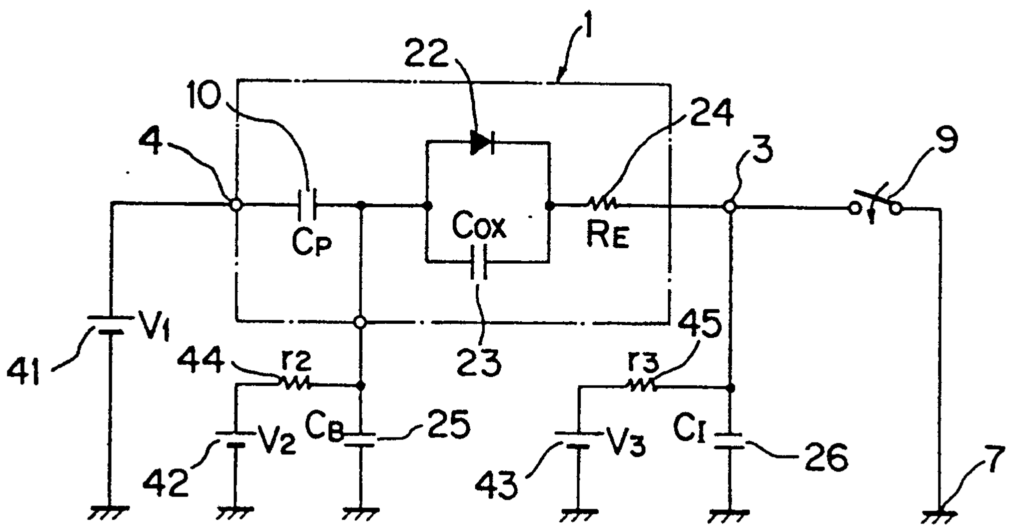
1
22
10
24
4
3
9
Cp
Cox
RE
V1
45
41
44
r2
23
r3
V2
CB
25
V3
CI
26
42
43
7

FIG.17

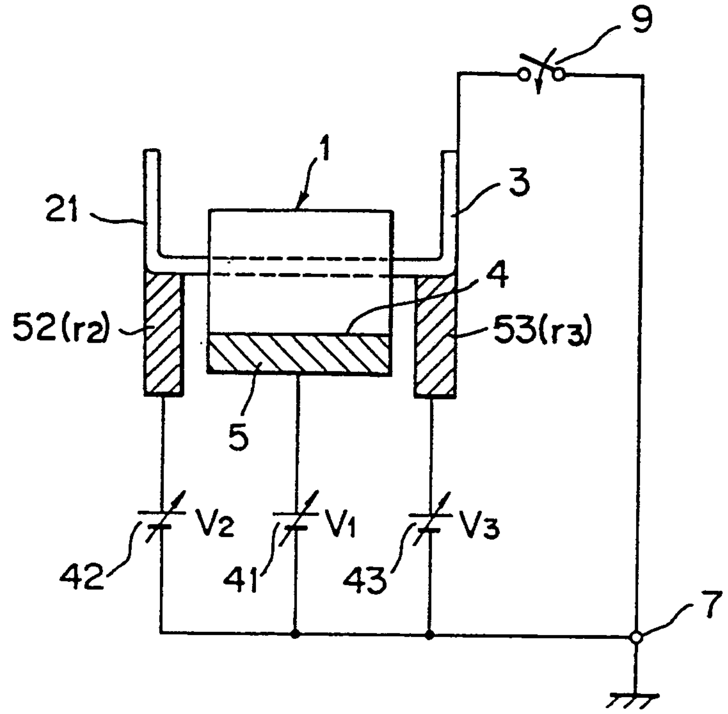
9
1
21
3
4
52(r2)
53(r3)
5
V2
V1
V3
42
41
43
7

FIG.18

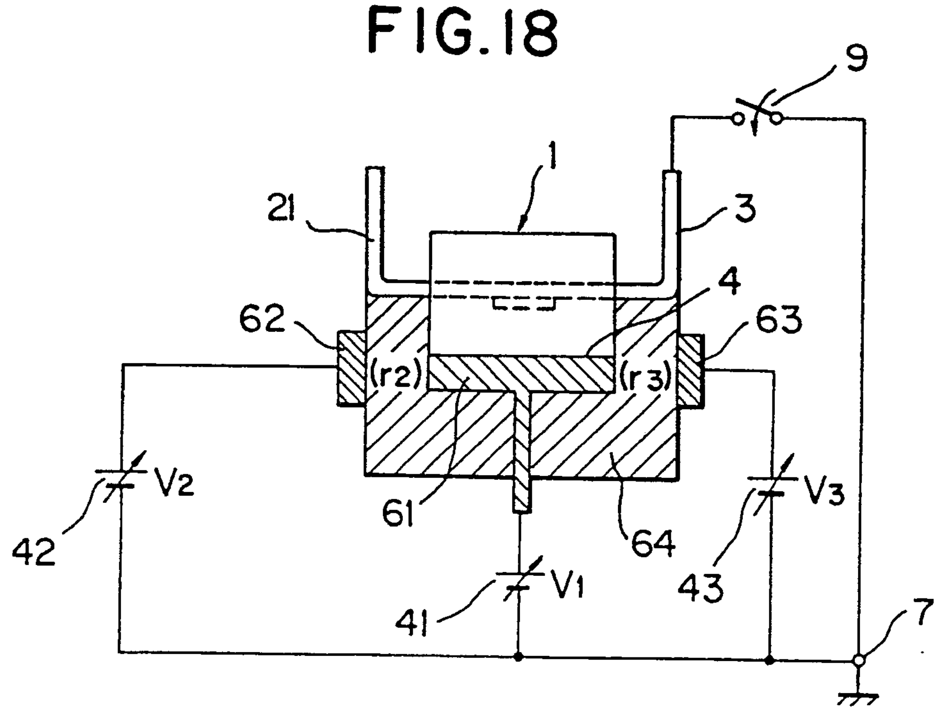
9
1
21
3
4
62
63
(r2)
(r3)
V2
V3
42
61
64
43
V1
41
7